Europäisches Patentamt

European Patent Office

Office européen des brevets

(11) Veröffentlichungsnummer: **0 177 760**
**B1**

# EUROPÄISCHE PATENTSCHRIFT

(45) Veröffentlichungstag der Patentschrift:
**17.05.89**

(21) Anmeldenummer: **85111191.4**

(22) Anmeldetag: **04.09.85**

(51) Int. Cl.⁴: **H01F 17/06**, H01F 15/02,
H01F 15/10

(54) Dämpfungsperle zur Unterdrückung von Störstrahlungen, insbesondere im Kurzwellen- und Ultrakurzwellenbereich.

(30) Priorität: **14.09.84 DE 3433831**

(43) Veröffentlichungstag der Anmeldung:
**16.04.86 Patentblatt 86/16**

(45) Bekanntmachung des Hinweises auf die Patenterteilung:
**17.05.89 Patentblatt 89/20**

(84) Benannte Vertragsstaaten:
**DE FR GB IT SE**

(56) Entgegenhaltungen:
EP-A- 0 134 556

PATENTS ABSTRACTS OF JAPAN, Band 6,
Nr. 254 (E-148) [1132], 14. Dezember 1982; & JP - A
- 57 154 809
PATENTS ABSTRACTS OF JAPAN, Band 7,
Nr. 174 (E-190) [1319], 2. August 1983; & JP - A
- 58 81 319
PATENTS ABSTRACTS OF JAPAN, Band 4,
Nr. 148 (E-30) [630], 18. Oktober 1980; & JP - A
- 55 98 803
PATENTS ABSTRACTS OF JAPAN, Band 9,
Nr. 39 (E-297) [1762], 19. Februar 1985; & JP - A
- 59 181 005

(73) Patentinhaber: **Siemens Aktiengesellschaft Berlin und München, Wittelsbacherplatz 2, D-8000 München 2(DE)**

(72) Erfinder: **Häckel, Hans, Dipl.-Ing. (FH), Martin-Ernst-Strasse 6, D-8400 Regensburg(DE)**
Erfinder: **Schindler, Josef, Alfons-Bayerer-Strasse 9, D-8400 Regensburg(DE)**

## Beschreibung

Die Erfindung betrifft eine Dämpfungsperle zur Unterdückung von Störstrahlungen insbesondere im Kurzwellen- und Ultrakurzwellenbereich mit einem aus Ferrit gefertigten Rohr.

Aus Ferrit gefertigte Dämpfungsperlen der vorerwähnten Art sind bereits seit langem bekannt und insbesondere für die genannten Einsatzbereiche geeignet. Über einen Leiter geschoben, rufen die Dämpfungsperlen eine Dämpfung hervor, welche mit der Anzahl der Perlen ansteigt. Eine Vormagnetisierung der Dämpfungsperlen setzt dabei die Dämpfung herab.

Der vorliegenden Erfindung liegt die Aufgabe zugrunde, eine Dämpfungsperle in Chip-Form zu schaffen, die zur Magazinierung und folglich zum Einsatz in Bestückungsautomaten für z.B. gedruckte Schaltungen geeignet ist.

Die Lösung dieser Aufgabe sieht eine als Chip-Bauelement gestaltete Dämpfungsperle mit stirnseitigen Kontaktelementen vor, die durch Leiterelemente im Rohrinneren miteinander elektrisch leitend verbunden sind.

Die stirnseitigen Kontaktelemente sind z.B. als metallisierte und mit Weichlot beschichtete Stirnseiten ausgebildet. Die Leiterelemente selbst können z.B. gleichfalls aus Weichlot, insbesondere hochschmelzendem Weichlot oder aus einer Metallschicht bestehen, die auf die Rohrinnenwände aufgebracht ist.

Als Leiterelemente sind auch Drähte geeignet, die durch das Rohrinnere geführt, an den Stirnenden der Dämpfungsperle kurbelartig herausgeführt und an ihren Enden plattgedrückt sind. Die plattgedrückten Enden können auch in Richtung zum Rohr geführt sein.

Die so gestalteten, ggf. blockförmig mit Vergußmasse, z.B. Epoxydharz, umhüllten Dämpfungsperlen sind bevorzugt magaziniert und als solche für den Einsatz in Bestückungsautomaten für gedruckte Schaltungen geeignet.

Ausführungsbeispiele des Gegenstandes nach der Erfindung sind in der Zeichnung dargestellt.

Es zeigt:

Fig. 1 einen Längsschnitt durch ein erstes Ausführungsbeispiel des Gegenstandes nach der Erfindung,

Fig. 2 eine Seitenansicht der Dämpfungsperle nach Fig. 1,

Fig. 3, 4 in der Darstellung nach Fig. 1, 2 ein zweites Ausführungsbeispiel des Gegenstandes nach der Erfindung,

Fig. 5 in teils geschnittener Ansicht ein drittes Ausführungsbeispiel des Gegenstandes nach der Erfindung,

Fig. 6 eine Draufsicht auf die Dämpfungsperle nach Fig. 5,

Fig. 7, 8 in der Darstellung nach Fig. 5, 6 ein viertes Ausführungsbeispiel des Gegenstandes nach der Erfindung.

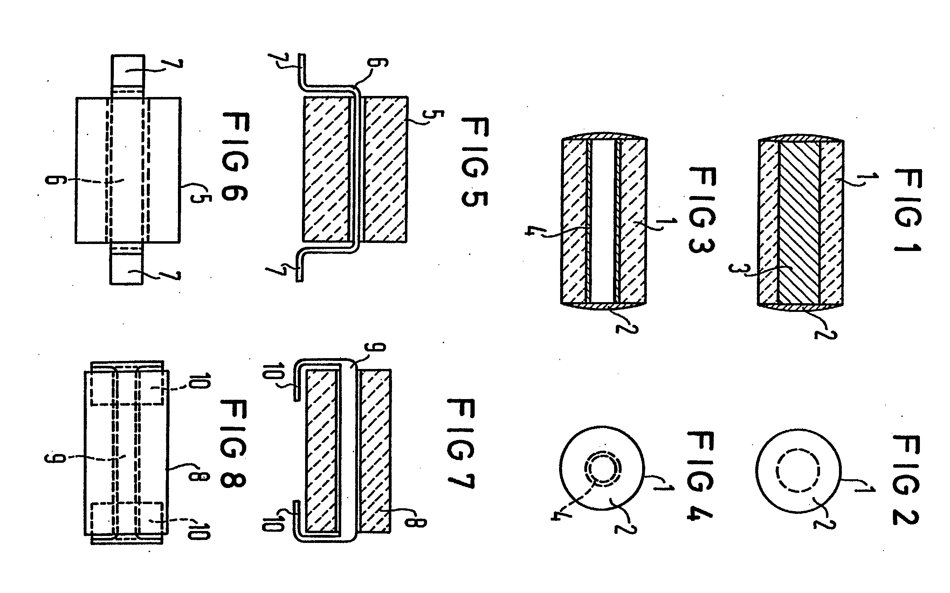

Das als Dämpfungsperle geeignetes Chip-Bauelement nach Fig. 1, 2 besitzt ein aus Ferrit gefertigtes Rohr 1, dessen Rohrinneres nach Metallisierung mit hochschmelzendem Weichlot 3 gefüllt ist. Stirnseitig steht dieses Weichlot mit Weichlotschichten 2 in elektrisch leitender Verbindung, die nach einem der an sich bekannten Verfahren auf die Rohrstirnwände aufgebracht sind.

Diese als Chip-Bauelemente gestalteten Dämpfungsperlen sind als Schüttgut oder magaziniert, z. B. gegurtet lieferbar. Ihre Kennzeichnung mit den jeweiligen Dämpfungswerten kann durch entsprechend aufgebrachte Farbpunkte, Farbstreifen, Farbringe und bei geeigneter Größe auch durch entsprechende Aufdrucke erfolgen.

Beim Ausführungsbeispiel nach Fig. 3, 4 ist das im Rohrinneren nach Metallisierung angeordnete Weichlot 3 nach Fig. 1, 2 durch eine Metallschicht 4 ersetzt, welche die Rohrinnenwände bedeckt und die stirnseitigen Weichlotschichten elektrisch leitend miteinander verbindet.

Beim Ausführungsbeispiel nach Fig. 5, 6 sind die Weichlote und Metallschichten nach Fig. 1 bis 4 durch einen Metallstreifen 6 ersetzt. Dieser Metallstreifen ist an den einen Stirnseiten eines ggf. quaderförmigen Ferritkörpers 5 kurbelartig, d.h. zweimal im rechten Winkel abgewinkelt und an seinen Enden 7 plattgedrückt. Mittels ihrer Enden 7 werden die Dämpfungsperlen z.B. auf Leiterbahnen von Leiterplatten aufgelötet.

Bei der Dämpfungsperle nach Fig. 7, 8, die gleichfalls ein quaderförmiges Ferritrohr 8 aufweisen kann, ist ein Draht 9 gleichfalls an beiden Stirnenden des Rohres 8 herausgeführt, jedoch mit seinen plattgedrückten Enden 10 parallel in Richtung zum Rohr 8 umgelegt.

## Patentansprüche

1. Dämpfungsperle zur Unterdrückung von Störstrahlung, insbesondere im Kurzwellen- und Ultrakurzwellenbereich, mit aus Ferrit gefertigtem Rohr, gekennzeichnet durch die Verwendung als Chip-Bauelement mit stirnseitigen Kontaktelementen, die durch Leiterelemente (3, 4, 6, 9) im Rohrinneren miteinander elektrisch leitend verbunden sind.

2. Dämpfungsperle nach Anspruch 1, dadurch gekennzeichnet, daß die Stirnseiten mit Weichlot (2) beschichtet und das Rohrinnere nach Metallisierung mit Weichlot (3) gefüllt ist (Fig. 1, 2).

3. Dämpfungsperle nach Anspruch 1, dadurch gekennzeichnet, daß die Stirnseiten nach Metallisierung mit Weichlot (2) und die Rohrinnenwände mit Metall (4) beschichtet sind (Fig. 3, 4).

4. Dämpfungsperle nach Anspruch 1, dadurch gekennzeichnet, daß durch das Rohrinnere ein Draht (6, 9) geführt und an den Stirnflächen abgewinkelt aus dem Rohrinneren herausgeführt ist (Fig. 5 bis 8).

5. Dämpfungsperle nach Anspruch 1 und 4, dadurch gekennzeichnet, daß der Streifen (6) kurbelartig aus dem Körperinneren herausgeführt und an seinen Enden (7, 7) plattgedrückt ist (Fig. 5, 6).

6. Dämpfungsperle nach Anspruch 1, 4 und 5, dadurch gekennzeichnet, daß der Draht (9) aus dem Rohrinneren herausgeführt ist und seine plattgedrückten Enden (10, 10) entsprechend der gewünschten Anschlußform umgelegt sind (Fig. 7, 8).

## Claims

1. Attenuation bead for the suppression of interference radiation, in particular in the short-wave and ultra short-wave range, with tube made of ferrite, characterized by the use as chip component with end-face contact elements, which are connected electrically conductively to each other by conductor elements (3, 4, 6, 9) in the tube interior.

2. Attenuation bead according to Claim 1, characterized in that the end faces are coated with soft solder (2) and the tube interior is filled, after metallization, with soft solder (3) (Figs. 1, 2).

3. Attentuation bead according to Claim 1, characterized in that the end faces are coated, after metallization, with soft solder (2) and the tube inside walls are coated with metal (4) (Figs. 3, 4).

4. Attenuation bead according to Claim 1, characterized in that a wire (6, 9) is led through the tube interior and is led out from the tube interior, angled off at the end faces (Figs. 5 to 8).

5. Attenuation bead according to Claims 1 and 4, characterized in that the strap (6) is led out from the body interior in the manner of a crank and is pressed flat at its ends (7, 7) (Figs. 5, 6).

6. Attenuation bead according to Claims 1, 4 and 5, characterized in that the wire (9) is led out from the tube interior and its flat-pressed ends (10, 10) are folded over according to the desired form of connection (Figs. 7, 8).

## Revendications

1. Perle d'atténuation pour supprimer des rayonnements parasites, en particulier dans la plage des ondes courtes et des ondes ultra-courtes, avec un tube fabriqué avec une ferrite, caractérisée par son utilisation comme composant à puce avec des éléments de contact frontaux qui sont reliés électriquement entre eux par des éléments-conducteurs (3, 4, 6, 9), à l'intérieur du tube.

2. Perle d'atténuation selon la revendication 1, caractérisée par le fait que les côtés frontaux sont revêtus de brasage tendre (2) et que l'intérieur du tube est, après métallisation, rempli de brasage tendre (figures 1, 2).

3. Perle d'atténuation selon la revendication 1, caractérisée par le fait que les côtés frontaux sont revêtus, après métallisation, avec du brasage tendre (2), et les parois intérieures du tube sont revêtues avec du métal.

4. Perle d'atténuation selon la revendication 1, caractérisée par le fait que dans le tube est passé un fil (9) qui sort, avec un coude, de l'intérieur du tube (figures 5 à 8).

5. Perle suivant les revendications 1 et 4, caractérisée par le fait que la bande (6) sort de l'intérieur du corps, à la manière d'une manivelle, et elle est écrasée à ses extrémités pour présenter une forme plate (figures 5, 6).

6. Perle suivant les revendications 1, 4 et 5, caractérisée par le fait que le fil (9) sort de l'intérieur du tube et que ses extrémités (10, 10), écrasées pour se présenter sous forme plate, sont recourbées en fonction du mode de raccordement souhaité (figures 7, 8).

FIG 1

FIG 2

FIG 3

FIG 4

FIG 5

FIG 7

FIG 6

FIG 8